(19) Europäisches Patentamt
European Patent Office
Office européen des brevets

(11) **EP 1 006 628 B1**

(12) **FASCICULE DE BREVET EUROPEEN**

(45) Date de publication et mention de la délivrance du brevet:
**02.01.2004 Bulletin 2004/01**

(51) Int Cl.⁷: **H01S 5/14**, H01S 5/40

(21) Numéro de dépôt: **99402981.7**

(22) Date de dépôt: **30.11.1999**

(54) **Source multi-longueurs d'onde.**

Mehrwellenlängen-Quelle

Multi-wavelength source

(84) Etats contractants désignés:
**DE DK FR GB IT**

(30) Priorité: **04.12.1998 FR 9815367**

(43) Date de publication de la demande:
**07.06.2000 Bulletin 2000/23**

(73) Titulaire: **NETTEST PHOTONICS**
**78340 Les Clayes Sous Bois (FR)**

(72) Inventeurs:
• **Graindorge, Philippe**
**21800 Chevigny Saint Sauveur (FR)**
• **Martin, Philippe**
**78760 Ponchartrain (FR)**
• **Laloux, Bernard**
**78450 Villepreux (FR)**
• **Lefèvre, Hervé**
**75014 Paris (FR)**

(74) Mandataire: **Michelet, Alain et al**
**Cabinet Harlé et Phélip**
**7, rue de Madrid**
**75008 Paris (FR)**

(56) Documents cités:
**EP-A- 0 952 643** **GB-A- 2 202 404**

• **POGUNTKE K R ET AL: "DESIGN OF A MULTISTRIPE ARRAY GRATING INTEGRATED CAVITY (MAGIC) LASER" JOURNAL OF LIGHTWAVE TECHNOLOGY, vol. 11, no. 12, 1 décembre 1993 (1993-12-01), pages 2191-2200, XP000422683 ISSN: 0733-8724**
• **PATENT ABSTRACTS OF JAPAN vol. 005, no. 163 (E-078), 20 octobre 1981 (1981-10-20) & JP 56 090642 A (KYOTO GIKEN:KK), 22 juillet 1981 (1981-07-22)**
• **NYAIRO K O ET AL: "MULTIPLE CHANNEL SIGNAL GENERATION USING MULTICHANNEL GRATING CAVITY LASER WITH CROSSTALK COMPENSATION" ELECTRONICS LETTERS, vol. 28, no. 3, 30 janvier 1992 (1992-01-30), pages 261-263, XP000305964 ISSN: 0013-5194**

**Description**

Le développement des télécommunications optiques a montré l'intérêt de la mise en oeuvre de transmissions multiplexées en longueur d'onde. Ainsi, différents flux lumineux, susceptibles d'être chacun porteur d'une information différente, doivent transiter dans le même guide d'onde, par exemple dans la même fibre optique. On augmente alors considérablement les capacités de transmission du même moyen matériel constitué essentiellement par la fibre optique.

Jusqu'à présent, pour assurer ce multiplexage, on utilise généralement plusieurs sources, émettant chacune à une longueur d'onde qui lui est propre, et on assure leur couplage dans une fibre unique par l'intermédiaire d'un multiplexeur. Cette disposition donne souvent satisfaction. Toutefois, elle implique une multiplication du nombre de sources et donc de chacun de leurs composants et le recours à un multiplexeur collectant les flux lumineux émis par les différentes sources et les couplant à une même fibre.

Par ailleurs, il a été proposé (Patent Abstract of Japan - JP-A-56.090.642) un système de communications optiques comportant plusieurs lasers semi-conducteurs associés à un dispositif rétroréfléchissant unique. Chacun de ces lasers est vu par ce dispositif rétroréfléchissant sous un angle différent et forme avec lui une cavité différente. Chaque source ainsi formée émet donc à une longueur d'onde qui lui est propre. Cette disposition permet, par rapport à des systèmes entièrement disjoints, de limiter le nombre des composants nécessaires, mais requiert l'utilisation d'un multiplexeur pour coupler les flux émis par ces sources dans une fibre.

On connaît aussi par la demande de brevet britannique GB-A-2.202.404, un dispositif fournissant une source laser multi-longueur d'onde qui assure le couplage des différentes longueurs d'onde d'émission dans une fibre de sortie unique. Ce dispositif comporte des lasers associés à une cavité externe assurant la résonance de chacun d'eux à une longueur d'onde différente et le couplage des flux produits dans une fibre optique.

Ce document GB-2.202.404 indique que le laser, comme tout laser à cavité externe même monoguide d'onde, peut résonner sur plusieurs modes longitudinaux. De manière classique, il est proposé de remédier à cet inconvénient en utilisant une structure étalon. Celle-ci est formée dans la fibre de sortie, c'est-à-dire dans une zone où les faisceaux sont spatialement superposés.

Toutefois, dans une source à cavité externe multiguide d'onde, en plus ou même à la place des longueurs d'onde recherchées, des longueurs d'onde parasites peuvent être créées. L'explication paraît en être que, en plus de la sélection produite par les cavités qui correspondent pour un guide d'onde déterminé à un aller-retour unique du faisceau entre ce guide d'onde et le réflecteur externe, un tel dispositif forme aussi des cavités correspondant à plusieurs allers-retours du faisceau entre plusieurs guides amplificateurs et le réflecteur externe. Dans un laser particulier, le milieu amplificateur est ainsi susceptible de résonner à plusieurs longueurs d'onde acceptées par la cavité externe. Un tel conflit de modes est bien entendu néfaste et perturbe le fonctionnement de la source.

Le doument EP-A-0 952 643 présente une source laser de longueur d'onde accordable comportant notamment une cavité résonnante externe. Le filtrage de l'onde amplifiée est effectué dans la cavité résonnante par un interféromètre de Fabry-Pérot.

C'est un but de l'invention que de proposer une source multi-longueur d'onde qui ne présente pas ces défauts et dont le fonctionnement soit, de manière générale, optimisé.

A cet effet, l'invention concerne une source laser multi-longueur d'onde émettant un flux lumineux comportant autant de guides d'onde amplificateurs que de longueurs d'onde d'émission potentielles, une optique de collimation collimatant les faisceaux émis par les guides d'onde, un réseau et un rétroréflecteur constituant avec le réseau, un dispositif dispersif rétroréfléchissant qui définit avec chacun des guides d'onde une cavité externe résonnante, chaque guide d'onde ayant par rapport à sa cavité associée, une face intérieure et une face extérieure.

Selon l'invention, un interféromètre de Fabry-Perot ayant une faible finesse est placé dans la cavité entre l'optique de collimation et le réseau, ledit interféromètre étant incliné par rapport à l'axe de la cavité et constituant un filtre peu sélectif, dont la loi de variation de la longueur d'onde transmise en fonction de l'angle d'incidence est identique à celle du dispositif dispersif rétroréfléchissant.

Selon différents modes de réalisation présentant chacun leurs avantages particuliers et utilisables selon toutes leurs combinaisons techniquement possibles :

- la cavité externe résonnante est dans la configuration de Littman-Metcalf ;
- le flux lumineux émis est collecté au travers du rétroréflecteur et couplé dans une fibre monomode de sortie unique ;
- le rétroréflecteur est un miroir ;
- le rétroréflecteur est un système auto-aligné ;
- le rétroréflecteur est un dièdre ;
- le rétroréflecteur comporte une lentille cylindrique et un miroir partiellement réfléchissant ;
- un prisme disposé entre le réseau et l'optique de collimation assure une répartition linéaire des fréquences des flux lumineux produits par la source ;
- les guides d'onde amplificateurs sont identiques les uns aux autres ;
- les guides d'onde sont réalisés sur un même substrat semi-conducteur ;
- la face intérieure de chaque guide d'onde porte un revêtement anti-réfléchissant ;

- la face extérieure des guides d'onde est réfléchissante à 100 %.

L'invention sera ci-après décrite plus en détail en référence aux figures annexées sur lesquelles :

La figure 1 est une représentation de l'art antérieur utilisé pour présenter la configuration de Littman-Metcalf.

La figure 2 est une représentation vue de dessus de la source multi-longueur d'onde selon l'invention, dans un premier mode de réalisation.

La figure 3 est une représentation de cette même source vue de face.

La figure 4 est une représentation de cette même source vue de côté.

La figure 5 illustre les angles d'incidence des rayons centraux des faisceaux sur le réseau et sur l'interféromètre de Fabry-Perot.

La figure 6 est une représentation de la sélection en longueur d'onde réalisée, d'une part, par la cavité externe en l'absence d'interféromètre de Fabry-Perot, d'autre part, par l'interféromètre de Fabry-Perot placé dans cette cavité.

La figure 7 est une représentation vue de dessus de la source multi-longueur d'onde de l'invention, dans un deuxième mode de réalisation.

La figure 8 est une représentation de la source vue de côté dans son deuxième mode de réalisation.

La figure 9 est une représentation partielle schématisant la source munie d'un prisme de linéarisation des fréquences, vue de face.

La figure 10 est une représentation partielle schématisant la source munie d'un prisme de linéarisation des fréquences, vue de dessus.

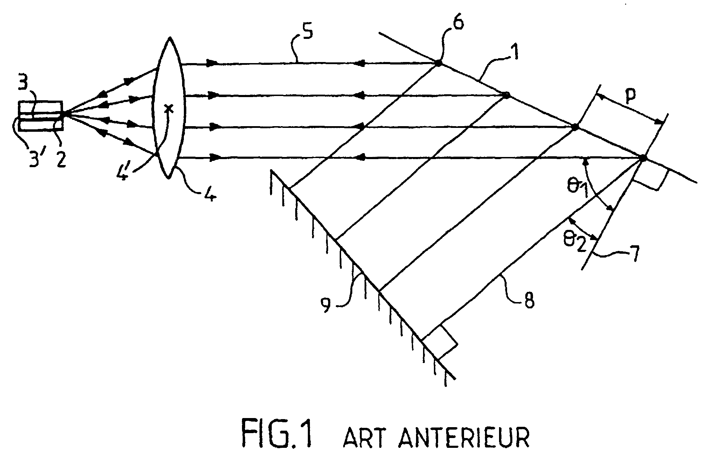

La figure 1 donne une représentation d'un montage connu de Littman-Metcalf dans lequel un réseau 1 est mis en oeuvre avec un milieu amplificateur guidé 3 comportant une extrémité extérieure 3' et dont l'extrémité intérieure 2 est placée au foyer d'une optique de collimation 4 qui produit un faisceau collimaté 5.

Ce faisceau est parallèle au plan de dispersion du réseau, c'est-à-dire au plan perpendiculaire au trait 6 du réseau 1 et forme un angle $\theta_1$ avec la normale 7 à la surface du réseau 1. Par dispersion chromatique créée par diffraction sur le réseau, le faisceau 5 produit un faisceau collimaté secondaire 8 qui est dans le plan de dispersion et forme un angle $\theta_2$ avec la normale 7. Un miroir plan 9 est traditionnellement placé perpendiculairement au faisceau 8 et le faisceau se réfléchit à travers l'ensemble du système.

On sait dans ces conditions que, p étant le pas du réseau, lorsque la relation

$$p \sin \theta_1 + p \sin \theta_2 = \lambda$$

est vérifiée, où $\theta_1$ est l'angle d'incidence du faisceau lumineux (dont la direction est définie par le centre de la face interne 2 du guide 3 et le centre 4' de l'optique de collimation 4) sur le réseau et où $\theta_2$ est l'angle de diffraction qui correspond à une direction perpendiculaire au miroir 9, le faisceau 5 de longueur d'onde $\lambda$ revient sur lui-même après une première diffraction sur le réseau 1, une rétroréflexion sur le miroir 9 et une deuxième diffraction sur le réseau 1. Il produit donc un point image confondu avec l'extrémité interne 2 du milieu amplificateur guidé 3. La lumière se recouple dans l'amplificateur guidé et permet une émission laser à la longueur d'onde $\lambda$.

Ce dispositif a été utilisé pour la réalisation de sources lumineuses émettant dans une bande de longueur d'onde étroite et il a été également été proposé des dispositions permettant de faire varier cette bande étroite de longueur d'onde (brevet EP-A-0.702.438).

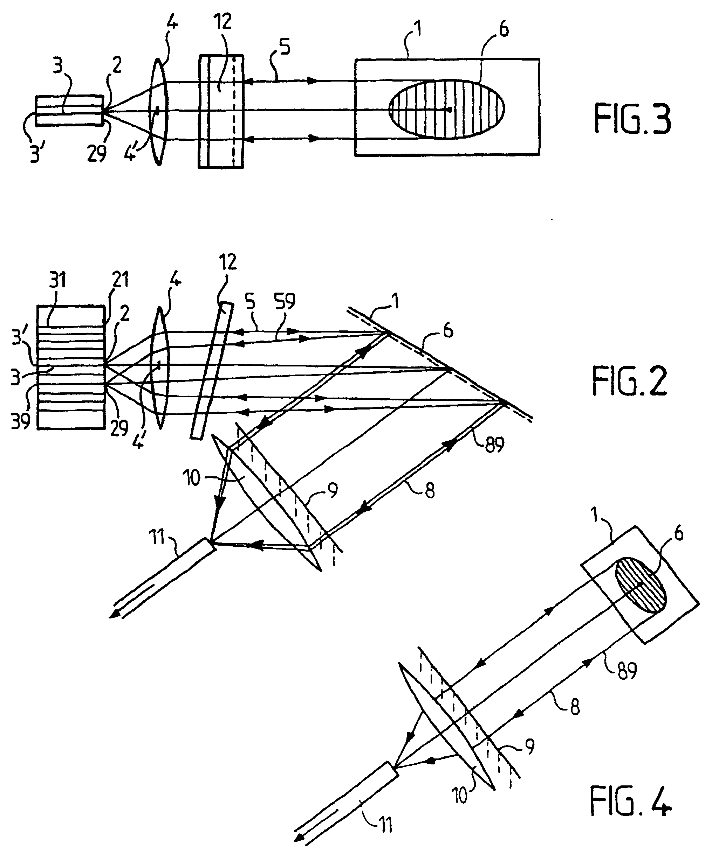

Sur les figures 2 à 4, est représenté le dispositif de l'invention dans un mode de réalisation où il met en oeuvre des principes fondamentaux de la configuration de Littman-Metcalf décrite plus haut. Les éléments correspondants à ceux déjà décrits sont désignés par les références numériques utilisées précédemment. Dans ce dispositif, plusieurs guides d'ondes amplificateurs de faces extérieures 3', 31',..., 39' ont leurs faces intérieures 2, 21, 22,..., 29 placées dans le plan focal F du système optique 4. Ainsi, chacun de ces guides d'ondes amplificateurs 3, 31,..., 39 définit un angle particulier $\theta_{1i}$, $(\theta_{11},..., \theta_{19})$, d'incidence sur le réseau. Par contre, le dispositif rétroréfléchissant 9 étant unique, l'angle $\theta_2$, qui correspond à l'incidence orthogonale sur le rétroréflecteur, est constant quel que soit le guide d'onde amplificateur 3, 31, ..., 39 considéré.

La suite de cette description sera faite en considérant uniquement les guides d'ondes amplificateurs 3 et 39. On comprend que le comportement généré par les guides d'ondes amplificateurs 31,..., 38 est analogue à celui du guide d'onde amplificateur 39.

Ainsi, pour la longueur d'onde $\lambda_1 = \lambda_9$, le faisceau 59 émis par le guide d'onde 39 est reçu par le réseau 1 sous un angle d'incidence $\theta_{1i} = \theta_{19}$ et dispersé sous l'angle $\theta_2$ sous la forme d'un faisceau 89.

Le guide d'onde amplificateur 39 définit donc un angle $\theta_{19}$ différent de $\theta_1$, la longueur d'onde $\lambda_9$ est sélectionnée par la cavité 9-39' formée par l'extrémité extérieure 39' de ce guide d'onde amplificateur 39 et le système rétroréfléchissant 9 et donc la longueur d'onde $\lambda_9$ satisfait la condition $\lambda_9 = p \sin \theta_{19} + p \sin \theta_2$.

Le système rétroréfléchissant 9 est partiellement rétroréfléchissant de telle sorte qu'une partie du flux lumineux résonnant dans les cavités 9-3' et 9-39' est extraite par ce système partiellement réfléchissant 9. Les faisceaux résonnants étant tous perpendiculaires au miroir 9 dans la cavité, ils restent parallèles entre eux en sortie et ils peuvent être couplés dans une même fibre optique monomode 11 avec un système optique 10.

On comprend en effet que le guide d'onde amplificateur 39 forme avec le système partiellement réfléchissant 9, une cavité résonante qui sélectionne, dans le spectre d'émission du guide d'onde amplificateur 39, la longueur d'onde $\lambda_9$, et que les flux lumineux ayant les longueurs d'onde respectives $\lambda$ et $\lambda_9$ sont superposées dans la partie de la cavité comprise entre le réseau 1 et le système partiellement réfléchissant 9, et qu'elles sont donc émises au travers du système partiellement rétroréfléchissant 9, selon une même direction. L'optique de couplage 10 permet donc le couplage simultané dans la fibre monomode 11 du flux lumineux à la longueur d'onde $\lambda$ et du flux lumineux à la longueur d'onde $\lambda_9$.

Chacun des milieux amplificateurs 3, 31,..., ou 39 dont l'extrémité intérieure est placée dans le plan focal de l'optique de collimation 4, forme une cavité 9-3', 9-31',..., ou 9-39' et produit un flux lumineux traité de manière analogue et est donc couplé dans la fibre de sortie 11.

Les milieux amplificateurs 3, 31,..., 39 sont avantageusement des amplificateurs semi-conducteurs tels que des diodes. L'application d'un signal de commande électrique permet, en modulant indépendamment la puissance de chacune de ces diodes, c'est-à-dire de chacun des canaux transmis par la fibre, de transmettre l'information correspondante aux différents signaux de commande électrique.

On a constaté qu'en dehors de la cavité résonante formée par exemple par le guide d'onde amplificateur 39 avec le système partiellement réfléchissant 9, on peut également obtenir des cavités résonantes à partir du guide d'onde amplificateur 39 par réflexion sur le système partiellement réfléchissant 9, puis par recouplage dans un deuxième guide d'onde, par exemple le guide d'onde 31, puis une nouvelle réflexion sur le système partiellement réfléchissant 9 et enfin retour au guide d'onde amplificateur 39.

Cette double cavité résonante est donc susceptible de produire des effets parasites pouvant, dans certaines conditions, perturber ou même dominer ceux produits par la première cavité principale, celle qui sélectionne dans le spectre d'émission du guide d'onde amplificateur 39, la longueur d'onde $\lambda_i = \lambda_9$. L'émission à cette longueur d'onde $\lambda_i = \lambda_9$ est alors perturbée, ce qui est évidemment néfaste pour le fonctionnement de la source.

On peut éviter ces perturbations en prévoyant un filtrage complémentaire évitant une émission laser qui met en jeu plusieurs guides amplificateurs.

En effet, la loi de sélection des longueurs d'onde dans les cavités simples 9-3i'(i = 1 à 9) est comme nous l'avons vu :

$$\lambda_i = p \sin \theta_{1i} + p \sin \theta_2$$

où i = 1 à 9.

De son côté, un interféromètre de Fabry-Perot a aussi une dépendance angulaire de la longueur d'onde de transmise $\lambda_t$ :

$$\lambda_t = \lambda_n \cos \theta_{FPi}$$

où $\lambda_n$ est la longueur d'onde transmise à l'incidence normale et $\theta_{FPi}$ est l'angle entre la normale au Fabry-Perot et la direction du faisceau i.

On a trouvé qu'il est possible de choisir l'inclinaison du Fabry-Perot, de façon à ce que les deux lois de variation soient identiques.

Dans le cas d'une configuration de Littrow qui pourrait être mise en oeuvre, dans le cadre de l'invention, à la place de la configuration de Littman-Metcalf à laquelle il a été fait référence jusqu'à maintenant, où $\lambda_i = 2 p \sin \theta_{1i}$, il suffit que le Fabry-Perot soit perpendiculaire au réseau avec $\lambda_n = 2 p$, alors $\theta_{1i} = 90° - \theta_{FPi}$ et sin $\theta_{1i} = \cos \theta_{FPi}$.

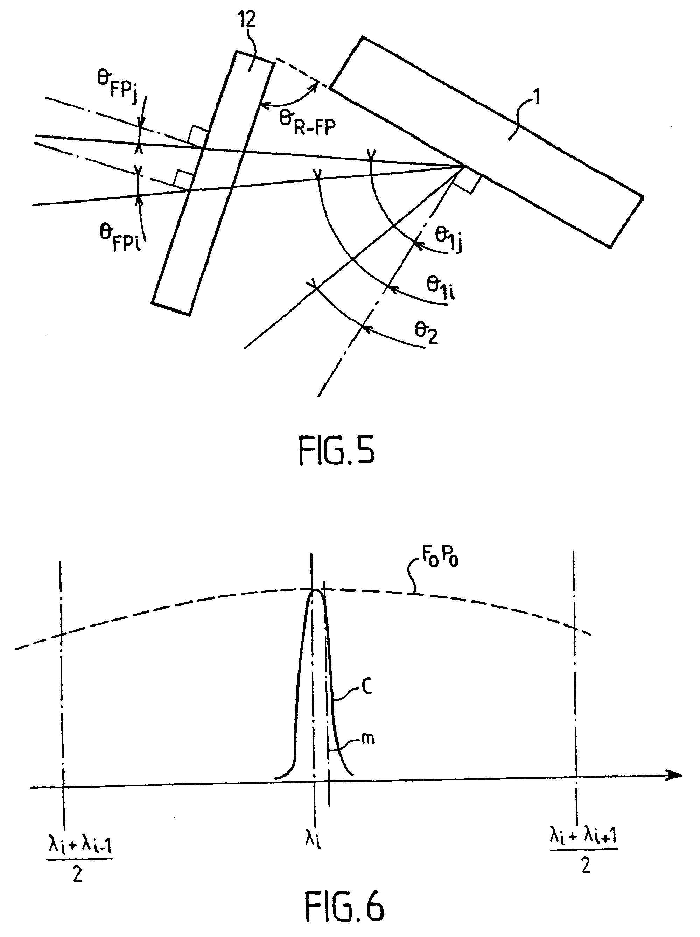

Dans le cas d'une configuration de Littman-Metcalf détaillée en figure 5, la loi est plus complexe mais il suffit d'égaliser les dispersions angulaires, c'est-à-dire les dérivées de la loi du réseau et de celle du Fabry-Perot. A titre indicatif, on a obtenu de bons résultats pour un angle incident moyen $\theta_{FPi}$ (angle d'incidence du faisceau sur le Fabry-Perot) de l'ordre de 8° et un angle d'incidence moyen sur le réseau de l'ordre de 75°. On a ainsi un angle $\theta_{R-FP}$ formé par le plan du réseau avec celui du Fabry-Perot de l'ordre de 83°.

Le Fabry-Perot est alors transparent pour les différentes cavités simples fonctionnant avec une longueur d'onde $\lambda_i$, une incidence $\theta_{1i}$ sur le réseau et $\theta_{FPi}$ sur le Fabry-Perot.

Maintenant, un fonctionnement en cavité double entre les guides 3i et 3j conduit toujours aux incidences $\theta_{1i}$, $\theta_{1j}$ sur le réseau et $\theta_{FPi}$, $\theta_{FPj}$ sur le Fabry-Perot. Cependant, la longueur d'onde d'émission serait alors $(\lambda_i + \lambda_j)/2$ et comme cette longueur d'onde est atténuée par le Fabry-Perot aux incidences $\theta_{FPi}$, $\theta_{FPj}$, il ne peut plus y avoir d'effet laser pour cette cavité double.

La longueur d'onde $(\lambda_i + \lambda_j)/2$ étant en pratique éloignée de $\lambda_i$ et de $\lambda_j$, et une cavité double conduisant à quatre passages dans le Fabry-Perot, il lui suffit d'avoir une faible finesse pour éliminer l'effet laser sur les cavités doubles.

Selon l'invention, il a été constaté qu'il est ainsi possible de réaliser par un seul composant, le filtrage nécessaire sur toutes les longueurs d'onde d'émission.

Ce moyen est constitué par un Fabry-Perot 12, placé entre l'optique de collimation 4 et le réseau 1, là où les incidences des différents faisceaux sont différentes les unes des autres, et incliné par rapport à l'axe moyen de la cavité.

Sur la figure 6, on a représenté en traits semi-continus 'm' les longueurs d'onde des modes longitudinaux susceptibles d'être acceptées par une cavité externe, en traits continus 'c' la fonction de filtrage du réseau, et en pointillés $F_oP_o$ la bande passante de l'interféromètre de Fabry-Perot 12 La cavité externe simple émet donc à la longueur d'onde $\lambda_i$ qui correspond à l'atténuation minimale du réseau.

Les émissions potentielles aux longueurs d'onde $(\lambda_i + \lambda_{i-1})/2$ et $(\lambda_i + \lambda_{i+1})/2$ dont l'élimination est recherchée par le Fabry-Perot 12 étant très décalées par rapport à la longueur d'onde $\lambda_i$ dont l'émission est recherchée, il n'est pas nécessaire que le Fabry-Perot soit très sélectif et un Fabry-Perot de faible sélectivité, c'est-à-dire dont les faces ont des coefficients de réflexion relativement faibles, assure le meilleur résultat.

Par exemple, une finesse de 5 à 10 pour un intervalle spectral libre de 30 nm est bien adaptée.

Dans un tel système, la fréquence de modulation du flux lumineux produite par le signal de commande électrique ne peut dépasser la fréquence de blocage de mode ("mode-locking") qui dépend de la longueur optique de la cavité et est d'autant plus élevée que celle-ci est courte.

Selon l'invention, il est possible de réaliser une cavité ayant une longueur de l'ordre de 15 mm, ce qui définit une fréquence de blocage de l'ordre de 10 GHz et permet une modulation pouvant aller jusqu'à une fréquence de 2,5 GHz.

Le flux lumineux étant extrait par le système partiellement réfléchissant 9, les faces extérieures 3', 31',..., 39' des milieux amplificateurs sont avantageusement entièrement réfléchissantes.

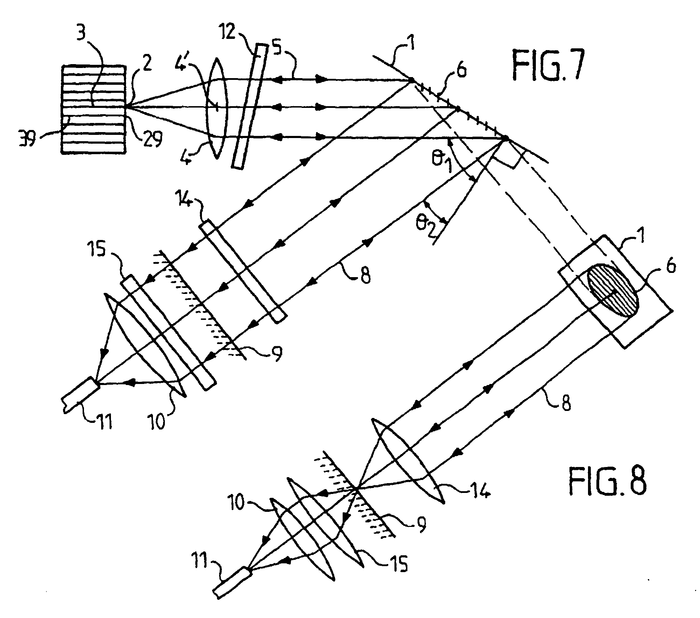

Dans un mode de réalisation préféré représenté sur les figures 7 et 8, la stabilité du système et son réglage sont facilités par l'utilisation d'une lentille cylindrique 14 faisant converger le faisceau vu de côté, dans une direction perpendiculaire au plan de dispersion du réseau, alors qu'elles ne l'affectent pas dans la direction parallèle. La lentille cylindrique 14 précède le miroir semi-réflecteur 9 qui contient sa droite foyer et une lentille cylindrique 15 placée après le miroir semi-réflecteur 9 rétablit le parallélisme du faisceau qui est alors couplé par le système optique 10 dans la fibre de sortie 11.

Les différents guides d'onde amplificateurs sont avantageusement identiques ou similaires les uns aux autres, réalisés sur le même substrat semiconducteur, et peuvent émettre dans les bandes spectrales généralement utilisées pour les télécommunications optiques par exemple entre 1530 nm et 1565 nm. Les longueurs d'onde ou fréquences sélectionnées dépendent de la focale du système optique 4, du pas du réseau 1, de l'espacement entre les coeurs des guides d'onde amplificateurs 3, 31,..., 39, et de l'orientation du réseau et du rétroréflecteur.

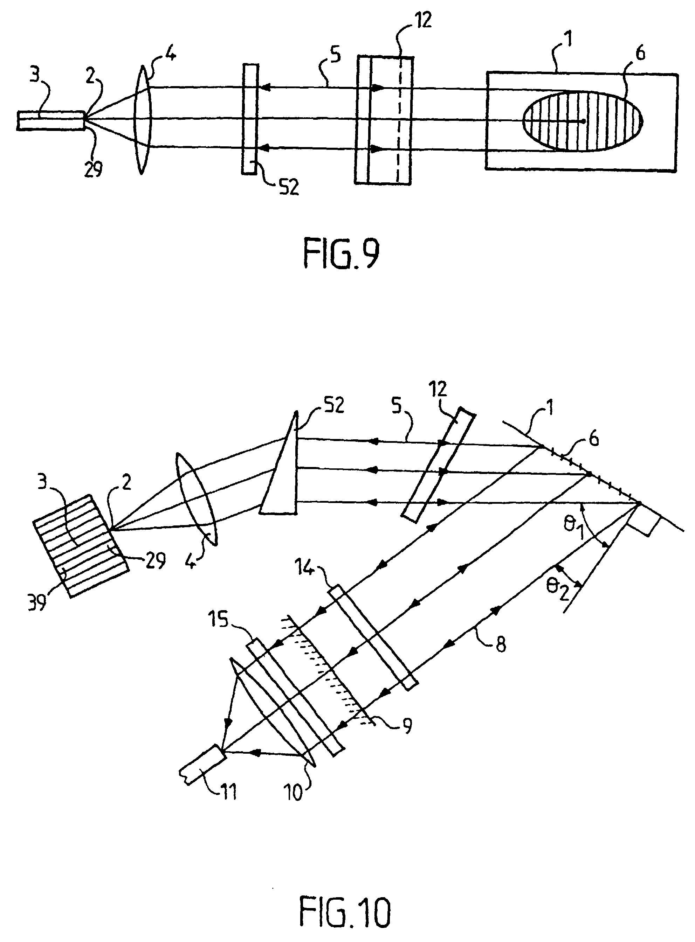

La relation, indiquée au début de cette description, existant entre les angles d'incidence et de réflexion sur le réseau et la longueur d'onde, fait ressortir qu'un espacement égal entre les coeurs des guides d'onde conduit à une répartition non linéaire des fréquences. Comme décrit dans les figures 9 et 10, un prisme 52, placé dans la partie amont, c'est-à-dire entre l'objectif de collimation 4 et le réseau 1 (de préférence entre l'optique de collimation 4 et le Fabry-Perot 12), produit un effet d'anamorphose qui augmente la dispersion et la sélectivité et par effet de la réfraction, introduit une non-linéarité qui compense la non-linéarité des lois de sélection angulaire du réseau et du Fabry-Perot. Lorsqu'une répartition équidistante des fréquences est recherchée, une telle disposition est avantageusement utilisée.

Le multiplexage en longueur d'onde est aussi utilisé pour augmenter la puissance de pompe d'un amplificateur optique. Une telle source multi-longueur d'onde pourrait être utilisée à cette application en particulier autour de 980 nm ou autour de 1480 nm pour le pompage des amplificateurs à fibre dopée erbium.

## Revendications

1.  Source laser multi-longueurs d'onde émettant un flux lumineux comportant autant de guides d'onde (31,..., 39) amplificateurs que de longueurs d'onde $(\lambda_1, ..., \lambda_9)$ d'émission potentielles, une optique (4) de collimation collimatant les faisceaux émis par les guides d'onde (31,..., 39), un réseau (1) et un rétroréflecteur (9) constituant avec le réseau (1), un dispositif dispersif rétroréfléchissant qui définit avec chacun des guides d'onde (31,..., 39) une cavité (9-31',..., 9-39') externe résonnante, chaque guide d'onde ayant par rapport à sa cavité associée, une face intérieure (21,..., 29) et une face extérieure (31',..., 39'), **caractérisée en ce qu'**un interféromètre (12) de Fabry-Pérot ayant une faible finesse est placé dans la cavité entre l'optique (4) de collimation et le réseau (1), ledit interféromètre (12) étant incliné par rapport à l'axe de la cavité et constituant un filtre peu sélectif, dont la loi de variation de la longueur d'onde transmise en fonction de l'angle d'incidence est identique à celle du dispositif dispersif rétroréfléchissant.

2.  Source selon la revendication 1, **caractérisée en ce que** la cavité externe résonnante est dans la configuration de Littman-Metcalf.

3.  Source selon la revendication 2, **caractérisée en ce que** le flux lumineux émis est collecté au travers du rétroréflecteur (9) partiellement transparent et couplé dans une fibre monomode de sortie unique.

4.  Source selon l'une quelconque des revendications 2 et 3, **caractérisée en ce que** le rétroréflecteur (9) est un miroir.

5.  Source selon l'une quelconque des revendications 2 et 3, **caractérisée en ce que** le rétroréflecteur (9) est un système auto-aligné.

6.  Source selon la revendication 5, **caractérisée en ce que** le rétroréflecteur (9) est un dièdre.

7. Source selon la revendication 5, **caractérisée en ce que** le rétroréflecteur (9) comporte une lentille cylindrique et un miroir partiellement réfléchissant.

8. Source selon l'une quelconque des revendications 1 à 7, **caractérisée en ce qu'**un prisme (52) disposé entre le réseau (1) et l'optique de collimation (4) assure une répartition linéaire des fréquences des flux lumineux produits par la source.

9. Source selon l'une quelconque des revendications 1 à 8, **caractérisée en ce que** les guides d'onde amplificateurs sont identiques les uns aux autres.

10. Source selon l'une quelconque des revendications 1 à 9, **caractérisée en ce que** les guides d'onde sont réalisés sur un même substrat semi-conducteur.

11. Source selon l'une des revendications 1 à 10, **caractérisée en ce que** la face intérieure (21,..., 29) de chaque guide d'onde porte un revêtement anti-réfléchissant.

12. Source selon l'une des revendications 1 à 11, **caractérisée en ce que** la face extérieure (31',..., 39') des guides d'onde est réfléchissante à 100 %.

**Patentansprüche**

1. Multiwellenlängen-Laserquelle, die einen Lichtstrahl sendet, der eben so viele verstärkende Wellenleiter (31, ..., 39) wie potenzielle Sendewellenlängen ($\chi_1$, ..., $\chi_9$), eine Visieroptik (4), die die von den Wellenleitern (31, ..., 39) abgegebenen Strahlen zielt, ein Netz (1) und einen Retroreflektor (9) umfasst, der mit dem Netz (1) eine dispersive retroflektierende Vorrichtung bildet, die mit jedem der Wellenleiter (31, ..., 39) einen externen widerhallenden Hohlraum (9-31', ..., 9-39') bildet, wobei jeder Wellenleiter in Bezug auf seinen zugeordneten Hohlraum eine innere Seite (21, ..., 29) und eine äußere Seite (31', ..., 39') hat, **dadurch gekennzeichnet, dass** ein Fabry-Pérot-Interferometer (12) mit schwacher Feinheit im Hohlraum zwischen der Visieroptik (4) und dem Netz (1) angeordnet ist, wobei das Interferometer (12) in Bezug auf die Achse des Hohlraums geneigt ist und ein schwach selektives Filter bildet, dessen Gesetz der Variation der in Abhängigkeit vom Einfallswinkel übertragenen Wellenlänge mit dem der dispersiven retroflektierenden Vorrichtung identisch ist.

2. Quelle nach Anspruch 1, **dadurch gekennzeichnet, dass** sich der gesendete externe widerhallende Hohlraum in der Littman-Metcalf-Konfiguration befindet.

3. Quelle nach Anspruch 2, **dadurch gekennzeichnet, dass** der Lichtstrahl durch den teilweise transparenten und in einer Einmodenfaser mit einzigem Ausgang gekoppelten Retroreflektor (9) gesammelt wird.

4. Quelle nach einem der Ansprüche 2 und 3, **dadurch gekennzeichnet, dass** der Retroreflektor (9) ein Spiegel ist.

5. Quelle nach einem der Ansprüche 2 und 3, **dadurch gekennzeichnet, dass** der Retroreflektor (9) ein selbstgefluchtetes System ist.

6. Quelle nach Anspruch 5, **dadurch gekennzeichnet, dass** der Retroreflektor (9) ein Dieder ist.

7. Quelle nach Anspruch 5, **dadurch gekennzeichnet, dass** der Retroreflektor (9) eine zylindrische Linse und einen teilweise reflektierenden Spiegel umfasst.

8. Quelle nach einem der Ansprüche 1 bis 7, **dadurch gekennzeichnet, dass** ein zwischen dem Netz (1) und der Visieroptik (4) angeordnetes Prisma (52) eine lineare Verteilung der Frequenzen der Lichtstrahlen, die die Quelle erzeugt, gewährleistet.

9. Quelle nach einem der Ansprüche 1 bis 8, **dadurch gekennzeichnet, dass** die verstärkenden Wellenleiter untereinander identisch sind.

10. Quelle nach einem der Ansprüche 1 bis 9, **dadurch gekennzeichnet, dass** die Wellenleiter auf einem gleichen Halbleitersubstrat hergestellt sind.

11. Quelle nach einem der Ansprüche 1 bis 10, **dadurch gekennzeichnet, dass** die innere Fläche (21, ..., 29) jedes Wellenleiters eine entspiegelte Beschichtung trägt.

12. Quelle nach einem der Ansprüche 1 bis 11, **dadurch gekennzeichnet, dass** die äußere Fläche (31', ..., 39') der Wellenleiter zu 100 % reflektierend ist.

**Claims**

1. A multiwavelength laser source emitting a luminous flux comprising as many amplifier wave-guides as potential emission wavelengths, a collimation optic system for collimating the beams emitted by the wave-guides, a network and a retroreflector making up with the grating, a dispersive retroreflecting device that defines with each wave-guide an external resonating cavity, whereas each wave-guide has an inner face and an outer face with respect to its associated cavity, wherein a Fabry-Perot interferometer with reduced fine adjustment is placed in the cavity between the collimation optic system and the grating, whereby the said interferometer is tilted with respect to the axis of the cavity and forms a little selective filter, whose variation law of the wavelength transmitted as a function of the angle of incidence is identical with that of the dispersive retroreflecting device.

2. A source according to claim 1, wherein the resonating external cavity is in the Littman-Metcalf configuration.

3. A source according to claim 2, wherein the luminous flux emitted is collected via the partially transparent retroreflector and coupled in a single output monomode fibre.

4. A source according to claims 2 and 3, wherein the retroreflector is a mirror.

5. A source according to claims 2 and 3, wherein the retroreflector is a self-aligned system.

6. A source according to claim 5, wherein the retroreflector is a dihedron.

7. A source according to claim 5, wherein the retroreflector comprises a cylindrical lens and a partially reflecting mirror.

8. A source according to any one of claims 1 to 7, wherein a prism arranged between the grating and the collimation optic system provides linear distribution of the frequencies of the luminous fluxes generated by the source.

9. A source according to any one of claims 1 to 8, wherein the amplifier wave-guides are identical with one another.

10. A source according to any one of claims 1 to 9, wherein the wave-guides are made over the same semiconductor substrate;

11. A source according to any one of claims 1 to 10, wherein the inner face of each wave-guide has an anti-reflecting coating.

12. A source according to any one of claims 1 to 11, wherein the outer face of the wave-guides is 100% reflecting.

FIG.1   ART ANTERIEUR

FIG.3

FIG.2

FIG.4

FIG.5

FIG.6

FIG.7

FIG.8

**FIG.9**

**FIG.10**